# DEMANDE DE BREVET EUROPEEN

(11) **EP 2 835 832 A2**
(43) Date de publication de la demande: **11.02.2015**
(21) Numéro de dépôt: 14180025.0
(22) Date de dépôt: 06.08.2014
(51) Int. Cl.: H01L 29/66

(54) **Procede ameliore de realisation de zones dopees et/ou exercant une contrainte sous les espaceurs d'un transistor**

(30) Priorité: 09.08.2013 FR 1357931
(71) Demandeur: Commissariat à l'Énergie Atomique et aux Énergies Alternatives, 75015 Paris (FR); STMICROELECTRONICS SA, 92120 Montrouge (FR)
(72) Inventeur: Batude, Perrine, 21000 Dijon (FR); Hartmann, Jean-Michel, 38420 Le Versoud (FR); Sklenard, Benoît, 38000 Grenoble (FR); Vinet, Maud, 38140 Rives Sur Fure (FR)
(74) Mandataire: Brevalex

(57) **Abrégé**

Procédé de réalisation d'un transistor comprenant des étapes de :
- formation de zones sacrificielles (114a, 114b) dans une couche semi-conductrice (103), de part et d'autre d'une région de canal d'un transistor,
- formation sur lesdites zones sacrificielles (114a, 114b,) d'espaceurs isolants (118a, 118b) contre des flancs de la grille dudit transistor,
- retrait desdites zones sacrificielles de manière à former des cavités (122a, 122b), les cavités s'étendant de part et d'autre de ladite région de canal et pénétrant sous lesdits espaceurs (118a, 118b),
- formation de matériau semi-conducteur dopé (123) dans lesdites cavités, ledit matériau semi-conducteur pénétrant sous lesdits espaceurs (118a, 118b).

## Description

Le transistor à effet de champ MOS est basé sur une modulation de la concentration de charges dans une région de canal par le biais d'une électrode de grille située au-dessus du canal et isolée de toutes les autres régions du dispositif par un diélectrique de grille. Un tel transistor comporte en outre des régions de source et de drain agencées de chaque côté de la région de canal et qui peuvent être formées dans une même couche semi-conductrice que celle dans laquelle se trouve le canal.

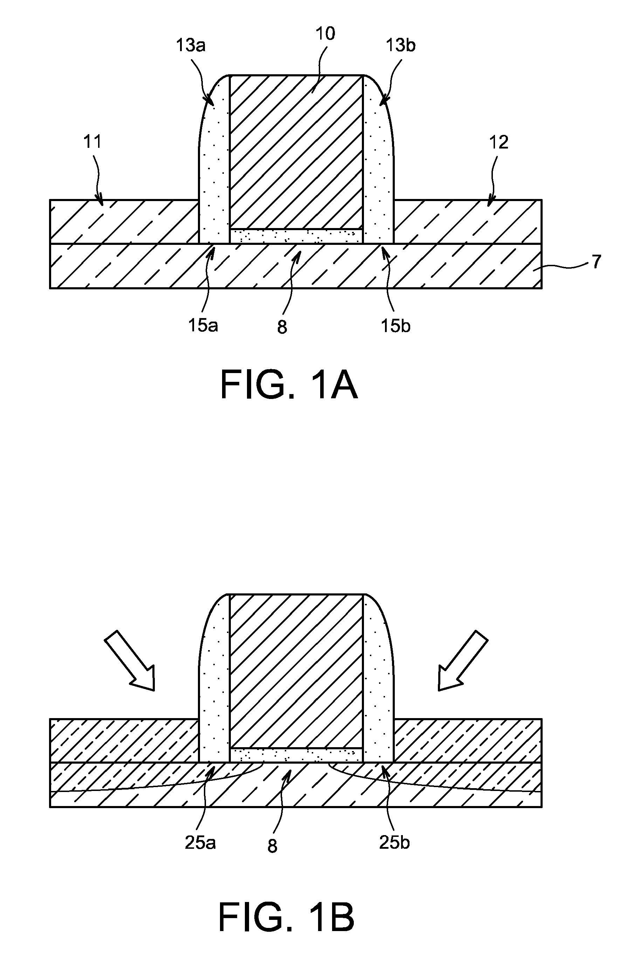

Afin d'améliorer les performances d'un transistor, il est connu de mettre en oeuvre des régions de source et de drain 11, 12 qui sont surélevées, c'est à dire qui sont réalisées au moins en partie dans des régions semi-conductrices qui s'étendent de part et d'autre d'une grille 10, au-dessus d'une couche semi-conductrice 7 dans laquelle un canal 8 est formé (figure 1A).

Les régions de source 11 et de drain 12 surélevées sont généralement formées par croissance épitaxiale durant laquelle elles peuvent être dopées.

Des espaceurs isolants 13a et 13b agencés contre les flancs latéraux de la grille sont prévus entre la grille 10 et les régions de source 11 et de drain 12.

Afin de limiter la résistance entre la zone de canal et les régions de source et de drain, on cherche à doper des zones 15a, 15b de la couche semi-conductrice 7 situées sous les espaceurs et qui se trouvent à la frontière de la zone de canal.

Le dopage de ces zones 15a, 15b peut comprendre un recuit thermique effectué après l'étape d'épitaxie des régions de source et de drain.

Cette étape de recuit thermique pose problème dans la mesure où elle nécessite un budget thermique important.

Dans le cadre de procédés de fabrication de transistors à basse température, c'est-à-dire au moins inférieure à 700°C, le dopage des zones 15a 15b, est ainsi généralement réalisé par implantation suivi également d'un recuit thermique, mais nécessitant un budget thermique plus faible.

Ce recuit doit de préférence être mené de manière à ne pas doper la zone de canal.

La figure 1B illustre des zones dopées 25a, 25b sous les espaceurs 13 qui ont été mal définies dans la mesure où elles s'étendent jusque dans la région semi-conductrice prévue pour le canal, en regard de la grille. Ces zones dopées 25a, 25b empiétant ainsi sur la zone de canal.

Pour éviter un empiétement trop important (communément appelé « overlap » selon la terminologie anglo-saxonne), une solution pourrait consister à réaliser les zones dopées sous les espaceurs par implantation.

Cependant cette solution peut alors nécessiter la mise en oeuvre d'étape(s) de photolithographie(s) supplémentaire(s).

Un dopage par implantation pose également problème lorsque la couche semi-conductrice que l'on cherche à doper est à base d'un matériau différent de celui des régions semi-conductrices formées par épitaxie de part et d'autre de la grille.

Lorsque ce matériau est prévu pour induire une contrainte, l'implantation peut entrainer une relaxation de cette contrainte.

Il se pose le problème de trouver un nouveau procédé, de réalisation d'un transistor ayant de meilleures performances et, amélioré vis-à-vis des inconvénients mentionnés ci-dessus.

### EXPOSÉ DE L'INVENTION

Un mode de réalisation de la présente invention prévoit un procédé de réalisation d'un dispositif microélectronique à transistor(s) comprenant des étapes de :
- formation de zones sacrificielles dans une couche semi-conductrice, les zones sacrificielles étant réalisées de part et d'autre d'une région donnée de cette couche semi-conductrice dans laquelle un canal d'un transistor est apte à être formé,
- formation contre une grille dudit transistor reposant sur ladite région donnée, d'espaceurs isolants reposant sur lesdites zones sacrificielles,
- retrait desdites zones sacrificielles de manière à former des cavités, les cavités s'étendant de part et d'autre de ladite région donnée sous lesdits espaceurs,
- formation d'un matériau semi-conducteur dans lesdites cavités et pénétrant sous les espaceurs, le matériau semi-conducteur formé dans les cavités et pénétrant sous les espaceurs étant dopé.

Un tel procédé permet de définir des zones dopées de part et d'autre de la région de canal et pénétrant sous les espaceurs tout en limitant le nombre d'étapes mises en oeuvre, en particulier d'étapes de photolithographie.

Ce procédé permet également de définir précisément des zones dopées pénétrant sous les espaceurs sans empiéter sur la région de canal.

Un tel procédé permet également de former des zones semi-conductrices dopées sous les espaceurs et en contact avec la zone de canal, sans nécessairement devoir réaliser une implantation sous les espaceurs pour effectuer ce dopage.

Le matériau semi-conducteur formé dans les cavités et pénétrant sous les espaceurs peut être adapté pour exercer une contrainte. Dans ce cas, un tel procédé permet d'appliquer cette contrainte au plus près du canal.

Par matériau adapté pour induire une contrainte, on entend que ce matériau semi-conducteur est différent de celui de ladite région donnée et choisi de manière à pouvoir étirer les atomes du matériau de ladite région donnée au-delà de leur distance interatomique ordinaire.

La formation du matériau semi-conducteur dans les cavités peut comprendre au moins une étape de croissance par épitaxie.

Avantageusement, ledit matériau semi-conducteur formé est alors dopé lors de la croissance par épitaxie dans les cavités. On réalise ainsi pendant cette ou ce(s) épitaxie(s), un dopage *in situ* dudit matériau semi-conducteur.

De préférence, lesdites zones sacrificielles sont à base d'un matériau sacrificiel, prévu pour pouvoir être gravé de manière sélective vis-à-vis du reste de ladite couche semi-conductrice. Ce matériau sacrificiel peut être semi-conducteur.

Selon une première possibilité de mise en oeuvre des zones sacrificielles, celles-ci peuvent être réalisées par :
- formation dans la couche semi-conductrice de cavités de part et d'autre de la grille dudit transistor,
- remplissage des cavités à l'aide d'un matériau sacrificiel.

La couche semi-conductrice peut être par exemple à base de Si, tandis que les zones sacrificielles sont à base de SiGe.

En variante, la couche semi-conductrice peut être à base de SiₓGe_{y}, tandis que les zones sacrificielles sont à base de SiₐGe_{b} avec b > y.

Selon une deuxième possibilité de mise en oeuvre des zones sacrificielles, celles-ci peuvent être des zones d'une couche semi-conductrice à base de matériau semi-conducteur cristallin que l'on a rendues amorphes.

Dans ce cas, les espaceurs isolants sont formés par dépôt de matériau diélectrique et de préférence après ces zones sacrificielles, le budget thermique de ce dépôt étant choisi de manière à conserver le caractère amorphe des zones sacrificielles ou de manière à induire une recristallisation seulement d'une épaisseur très faible de zones sacrificielles.

En particulier, la température de dépôt et la durée du dépôt sont choisies inférieures respectivement à une température seuil et à une durée seuil qui dépendent du matériau semi-conducteur des zones sacrificielles.

Les espaceurs isolants peuvent être formés directement en contact de la grille.

Selon une mise en oeuvre particulière du procédé dans laquelle la grille comprend une zone métallique, préalablement à la formation des zones sacrificielles, on peut réaliser des zones de protection contre la grille recouvrant ladite zone métallique.

On peut éviter ainsi une contamination du ou des équipements dans lequel ou dans lesquels on réalise l'étape de formation du matériau semi-conducteur sacrificiel dans les cavités.

Avantageusement, les régions de source et de drain sont réalisées de manière à être surélevées par rapport à la région de canal. Par « surélevées » on entend que les régions de source et de drain sont disposées de part et d'autre de la grille et s'étendent au moins partiellement au-dessus de ladite couche semi-conductrice dans laquelle la région de canal est prévue.

Un dispositif microélectronique obtenu à l'aide d'un procédé tel que défini plus haut est également prévu.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1B illustrent une réalisation, suivant l'art antérieur, de zones dopées sous les espaceurs isolants d'un transistor MOS ;
- les figure 2A-2F illustrent un exemple de procédé, suivant un mode de réalisation de l'invention, de mise en oeuvre d'un transistor dans lequel on forme sous les espaceurs du transistor un matériau semi-conducteur dopé et/ou adapté pour induire une contrainte par remplissage de cavités réalisées préalablement sous ces espaceurs ;
- les figures 3A-3E illustrent une variante de procédé de réalisation d'un transistor dans laquelle on forme des cavités sous les espaceurs du transistor par gravure de zones d'un matériau semi-conducteur rendu amorphe puis on remplit ces cavités par un matériau semi-conducteur dopé et/ou adapté pour exercer une contrainte, et qui est disposé en contact avec la zone de canal du transistor ;
- les figures 4A-4B illustrent une autre variante de procédé de réalisation de transistor dans laquelle des cavités sont formées sous les espaceurs du transistor par gravure sélective de zones sacrificielles à base d'un matériau semi-conducteur vis-à-vis d'un autre matériau semi-conducteur, puis remplies par un matériau semi-conducteur dopé et/ou adapté pour exercer une contrainte sur le canal du transistor;
- les figures 5A-5C, illustrent une autre variante de procédé dans laquelle des zones de protection sont réalisées sur une zone métallique de la grille d'un transistor préalablement à la réalisation d'espaceurs isolants ;
- les figures 6A-6B, illustrent un autre procédé, de fabrication d'un transistor dans lequel, après avoir réalisé des espaceurs, on forme de zones sacrificielles sous ces espaceurs qui sont destinées à être retirées ultérieurement pour former des cavités;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

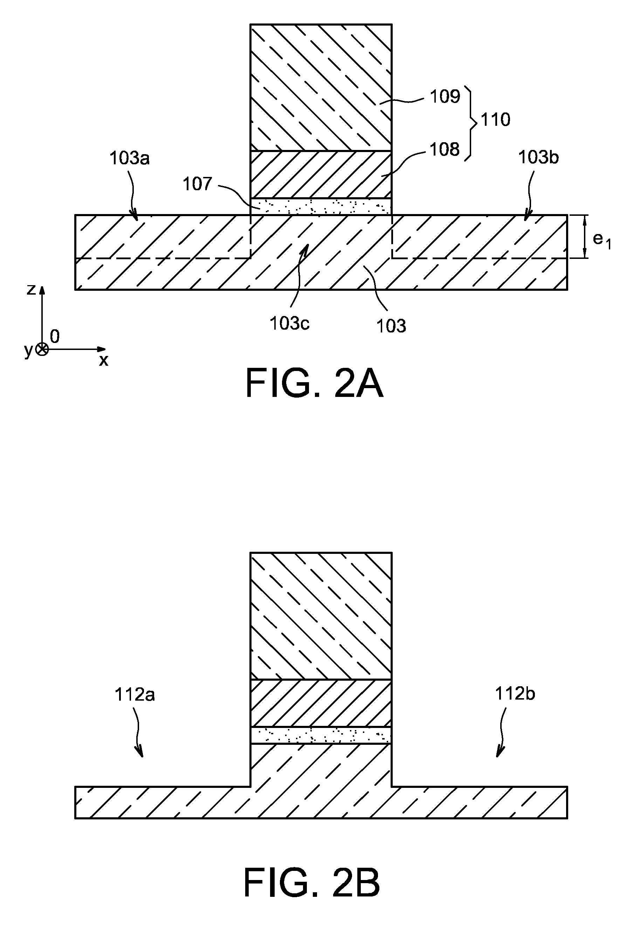

Un exemple de procédé, suivant l'invention, de réalisation d'un dispositif micro-électronique à transistor(s) va à présent être décrit en liaison avec les figures 2A-2F.

Le matériau de départ de ce procédé peut être un substrat de type semi-conducteur sur isolant par exemple de type SOI (SOI pour « silicium sur isolant ») qui comprend une couche de support semi-conducteur (non représentée) sur et en contact avec une couche isolante (non représentée) qui peut être à base d'oxyde de silicium et disposée sur et en contact avec la couche de support. Le substrat comporte également une fine couche semi conductrice 103 située sur et en contact avec ladite couche isolante.

Cette fine couche semi conductrice 103 peut avoir une épaisseur par exemple inférieure à 20 nm et qui peut être par exemple de l'ordre de 12 nm.

Des étapes de dépôt d'une couche de diélectrique 107 de grille et d'une ou plusieurs couches 108, 109 de matériau(x) de grille, puis de gravure de ces couches afin de réaliser un motif de grille 110 de transistor sont ensuite effectuées (figure 2A).

La grille 110 de ce transistor peut être formée d'un empilement d'une couche métallique, par exemple à base de TiN, sur laquelle repose une couche semi-conductrice, par exemple à base de polysilicium.

Puis, on effectue une étape de retrait de blocs 103a, 103b de la fine couche semi conductrice 103 situés de part d'une région 103c de cette fine couche semi conductrice 103 disposée en regard de la grille 107 et prévue pour former une zone de canal du transistor.

Ce retrait peut être réalisé à l'aide d'une gravure anisotrope, par exemple à l'aide de HCl et permet de former des cavités 112a, 112b disposées autour de la région 103c délimitant la zone de canal du transistor (Figure 2B).

L'épaisseur gravée de la fine couche conductrice 103 pour former des cavités 112a, 112b peut être inférieure à l'épaisseur totale de cette fine couche conductrice 103, et par exemple de l'ordre de 6 à 9 nm. On conserve ainsi, sous les cavités 112a, 112b, une portion de la fine couche semi-conductrice 103.

On comble ensuite les cavités 112a, 112b à l'aide d'un matériau sacrificiel 113, de manière à former des zones 114a, 114b sacrificielles de part et d'autre de la grille 110, qui sont destinées à être retirées ultérieurement.

L'épaisseur des zones 114a, 114b sacrificielles est prévue de préférence Inférieure à celle e₁ des blocs 103a, 103b de la fine couche semi conductrice 103 qui ont été retirées précédemment.

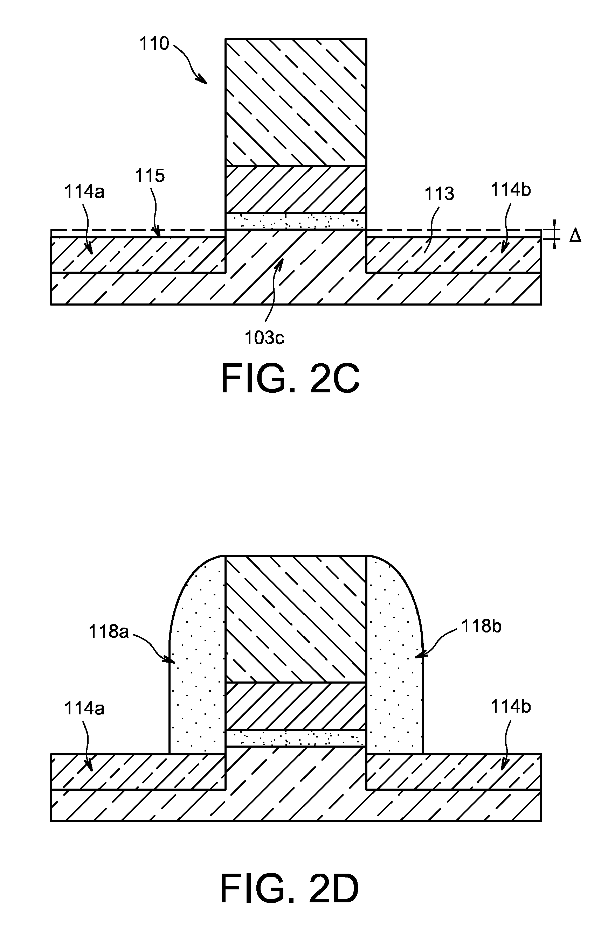

Ainsi, la face supérieure de la fine couche conductrice 103 sur laquelle repose le diélectrique de grille et la grille 110 dépasse légèrement au-dessus des faces supérieures 115 des zones 114a, 114b sacrificielles (Figure 2C). Un écart ou une longueur de dépassement Δ par exemple de l'ordre de 1 nm ou 2 nm peut être par exemple prévu, ce afin d'éviter de réaliser ultérieurement un court-circuit entre la grille et les zones de source et de drain.

Le matériau sacrificiel 113 de remplissage des cavités est de préférence un matériau choisi de manière à pouvoir être gravé de manière sélective vis-à-vis de celui de la fine couche semi-conductrice 103. Le matériau sacrificiel 113 peut être un matériau semi-conducteur tel que par exemple du SiₓGe_{y} avec y par exemple de l'ordre de 0,3. Lorsque le matériau sacrificiel 113 est un matériau semi-conducteur, on peut former ce dernier par croissance par épitaxie à partir de la fine couche semi-conductrice 103, ce qui permet de réaliser un contrôle précis de l'épaisseur des zones sacrificielles 114a, 114b.

Ensuite (figure 2D), on forme des espaceurs isolants 118a, 118b contre les flancs latéraux de la grille 110 et qui reposent sur les zones 114a, 114b de matériau sacrificiel 113. Les zones 114a, 114b de matériau sacrificiel 113 servent ainsi de support aux espaceurs isolants 118a, 118b.

Les espaceurs isolants 118a, 118b peuvent être réalisés par dépôt d'une couche de matériau diélectrique tel que par exemple du Si₃N₄, d'épaisseur par exemple de l'ordre de 10 nm, puis par gravure de ce matériau diélectrique.

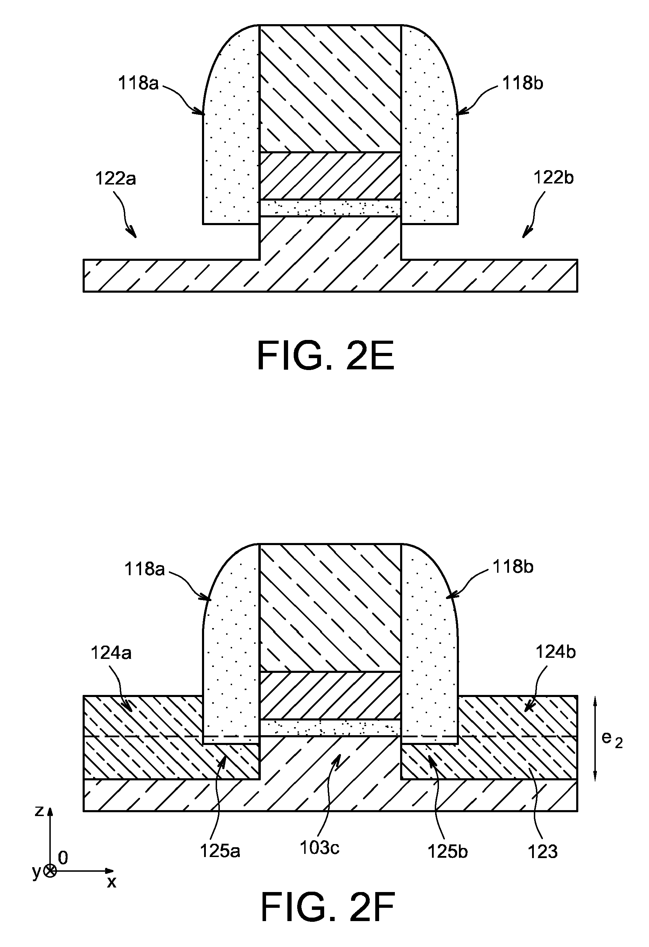

On effectue ensuite un retrait des zones 114a, 114b, et ce jusque sous les espaceurs 118a, 118b, de préférence à l'aide d'une gravure sélective et isotrope du matériau sacrificiel 113 vis-à-vis de celui de la fine couche semi-conductrice 103 (figure 2E).

Dans le cas où la fine couche semi-conductrice 103 est à base de Si et le matériau sacrificiel 113 est du SiGe, une gravure sélective à l'aide de HCl peut être par exemple mise en oeuvre.

On obtient ainsi à nouveau des cavités 122a, 122b autour de la zone de canal 103c, ces nouvelles cavités 122a, 122b étant ici également agencées de manière à s'étendre sous les espaceurs isolants 118a, 118b.

Les cavités 122a, 122b pénétrant sous les espaceurs isolants 118a, 118b sont ensuite comblé(e)s à l'aide d'un matériau semi-conducteur 123, de manière à former des blocs semi-conducteurs 124a, 124b de source et de drain (figure 2F). Le matériau semi-conducteur 123 peut être dopé, de sorte que des zones 125a, 125a dopées des blocs 124a, 124b qui sont situées sous les espaceurs 118a, 118b sont formées de part et d'autre de la région 103c de canal du transistor.

Les blocs semi-conducteurs 124a, 124b sont dans cet exemple réalisés à l'aide d'une ou plusieurs épitaxie(s) successives de matériau semi-conducteur que l'on fait croître à partir de l'épaisseur restante de la fine couche semi-conductrice 103. Lors de l'épitaxie ou des épitaxies, un dopage *in-situ* des blocs semi-conducteurs 124a, 124b est réalisé.

Les blocs semi-conducteurs 124a, 124b peuvent avoir une hauteur ou épaisseur e₂ supérieure à celle e₁ des zones 103a, 103b de la fine couche semi-conductrice 103 qui ont été retirées précédemment (les épaisseurs e₁ et e₂ étant mesurées dans une direction parallèle à l'axe z du repère orthogonal [O,x,y,z] indiqué sur les figures 2A et 2F). Ainsi, les blocs semi-conducteurs 124a, 124b dépassent par rapport à la face supérieure de la zone de canal 103c.

Les blocs semi-conducteurs 124a, 124b dopés s'étendent ainsi au-dessus de la face supérieure de la fine couche semi conductrice 103 et comportent une portion qui s'étend sous les espaceurs 118a, 118b.

On réalise ainsi des zones de source et de drains dopées qui sont surélevées par rapport à la zone de canal 103c sur laquelle repose la grille 110 du transistor, et pénètrent sous les espaceurs 118a, 118b de manière à être en contact avec des faces latérales de la zone de canal 103c.

Dans un cas où l'on forme un transistor de type PMOS, le matériau semi-conducteur 123 des blocs 124a, 124b peut être adapté pour induire une contrainte en compression sur la zone de canal 103c du transistor. Dans ce cas, le matériau semi-conducteur 123 de remplissage des cavités peut être, par exemple à base de silicium-germanium, et dopé, en particulier au Bore.

Dans un cas où l'on forme un transistor de type NMOS, le matériau semi-conducteur 123 des blocs 124a, 124b peut être adapté pour induire une contrainte en tension sur la zone de canal 103c du transistor. Dans ce cas, le matériau semi-conducteur 123 formé contre la zone de canal peut être, par exemple, à base de SiC, et dopé, en particulier au Phosphore.

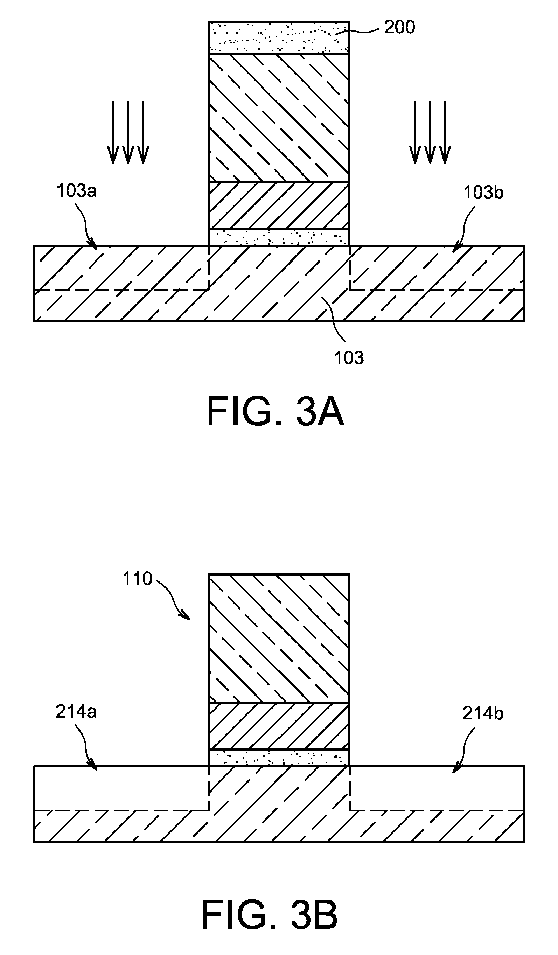

Une variante de l'exemple de procédé qui vient d'être décrit est illustrée sur les figures 3A-3B.

Selon cette variante, on forme des zones sacrificielles en rendant amorphes certaine régions de la fine couche semi-conductrice 103.

Pour cela, après avoir formé la grille 110, on peut réaliser une implantation de la couche 103 qui peut être par exemple à base de Si cristallin, et en particulier de blocs 103a, 103b de la fine couche semi conductrice 103 situés de part et d'autre d'une région 103c de cette fine couche semi conductrice 103 disposée en regard de la grille 107 et prévue pour former une zone de canal du transistor.

Cette implantation amorphisante des blocs 103a, 103b de matériau semi-conducteur peut être réalisée à travers un masquage 200 formé sur la grille 110, et à l'aide d'une espèce non dopante telle que par exemple du Ge ou de Si.

A l'issue de l'étape d'implantation, on obtient des zones 214a, 214b amorphes sacrificielles destinées à être retirées ultérieurement.

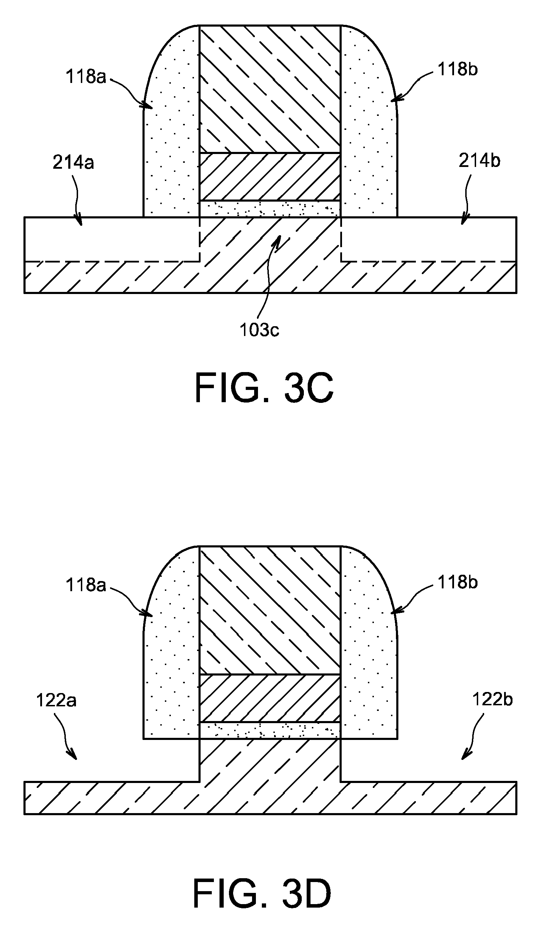

Ensuite (figure 3C), on forme des espaceurs isolants 118a, 118b contre les flancs latéraux de la grille 110 et qui reposent sur les zones 214a, 214b sacrificielles de matériau semi-conducteur rendu amorphe.

Afin de conserver le caractère amorphe des zones 214a, 214b sacrificielles, les espaceurs isolants 118a, 118b peuvent être formées par un dépôt dont le budget thermique, en particulier le couple temps/température, est choisi suffisamment faible pour ne pas induire de recristallisation ou pour induire une recristallisation superficielle des zones 214a, 214b sacrificielles d'une épaisseur d'au plus 2 nm.

Par exemple, dans le cas de zones de silicium, on peut prévoir un budget thermique de 500°C avec une durée inférieure à 1 min ou de 450°C avec une durée inférieure à 10 min dans le cas où le matériau de la couche 103 et des zones 214a, 214b est du silicium. Dans le cas par exemple de zones à base de Si ou de SiGe non dopé, le budget thermique maximum pour ne pas recristalliser l'accès peut être déterminé à partir de la référence : O. Hellman et al. Materials Science and engineering : R Reports volume 16 issue 1, 1996 p1-42

On réalise ensuite des étapes du type de celles données dans l'exemple de procédé décrit précédemment.

Ainsi, on effectue tout d'abord un retrait sélectif des zones sacrificielles 214a, 214b. Ce retrait peut être réalisé par exemple par gravure à l'aide de HCl lorsque la couche 103 est à base de Si cristallin et que les zones 214a, 214b sont à base de Si amorphe.

On obtient ainsi les cavités 122a, 122b qui s'étendent sous les espaceurs 118, 118b et de part et d'autre de la zone de canal 103c (figure 3D).

Ces cavités 122a, 122b sont ensuite comblées à l'aide d'un matériau semi-conducteur 123 dopé et/ou adapté pour induire une contrainte sur la zone 103c de canal.

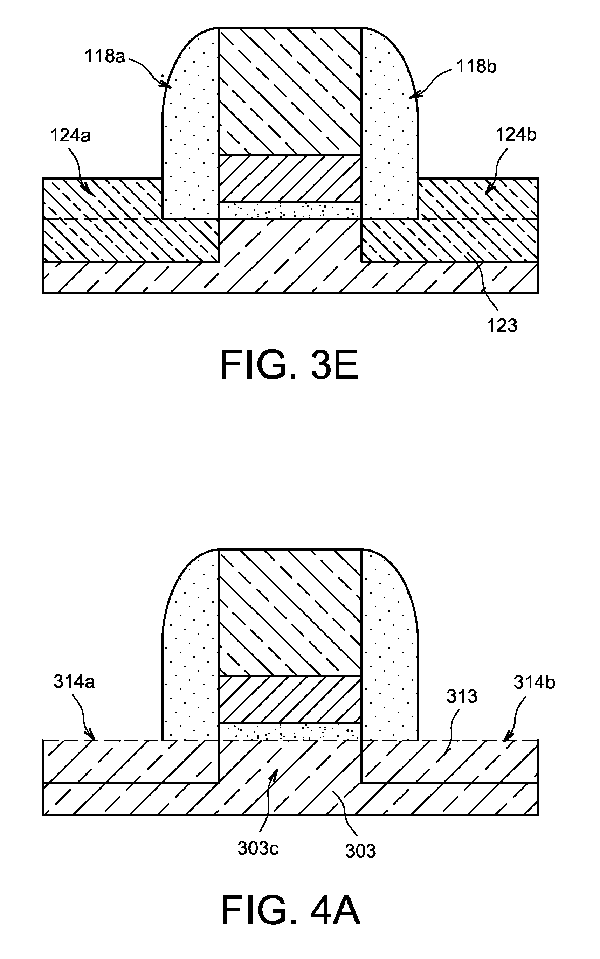

On forme ainsi des blocs semi-conducteurs 124a, 124b, de source et de drain, surélevés (figure 3E).

Selon une autre variante de réalisation, par exemple lorsque le transistor que l'on réalise est de type PMOS, le canal 303c de ce transistor peut être prévu dans une couche semi-conductrice 303 à base de SiₓGe_{y} sur laquelle la grille 110 est réalisée.

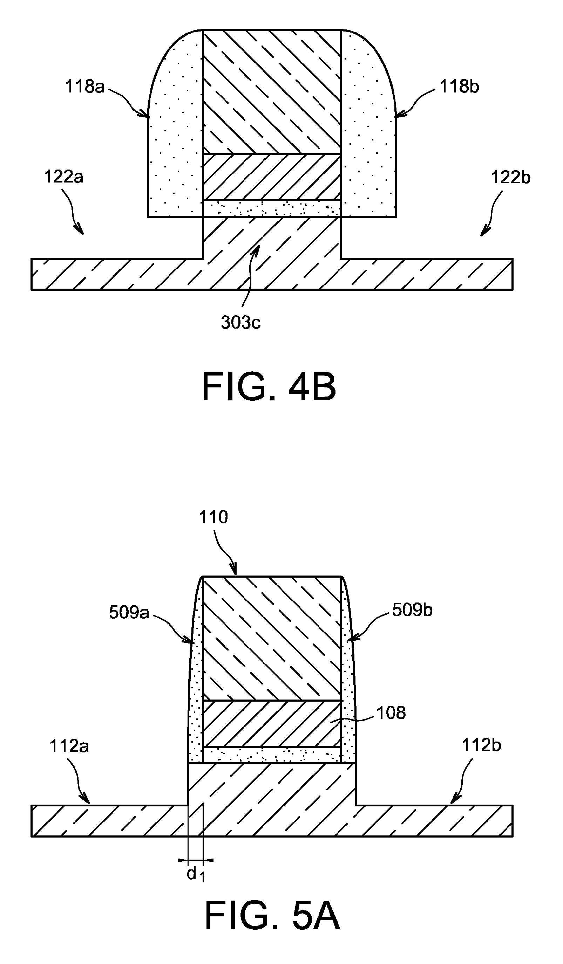

Des zones sacrificielles 314a, 314b à base de SiₐGe_{b} peuvent alors être formées de part et d'autre de la grille 110 avec b>y et a<x (figure 4A), puis des espaceurs 118a, 118b sont réalisés sur ces zones 114a, 114b (figure 4A).

On peut ensuite effectuer une gravure sélective des zones sacrificielles 314a, 314b à base de SiₐGe_{b} vis-à-vis de la couche 303 de SiₓGe_{y} ayant une concentration en Ge plus élevée que celle de ces zones, de manière à former notamment les cavités 122a, 122b sous les espaceurs 118a, 118b sans graver la zone de canal.

Cette gravure peut être réalisée par exemple à l'aide de HCl, à basse température, par exemple inférieure à 700°C.

Ensuite, les zones de source et de drain peuvent être formées, par exemple comme cela été décrit précédemment en liaison avec la figure 2F, par croissance par épitaxie dans les cavités 122a, 122b d'un matériau semi-conducteur 123 en contact avec la région 303c de canal et pénétrant sous les espaceurs 118a, 118b, ce matériau semi-conducteur étant dopé et/ou adapté pour induire une contrainte sur la région 303c de canal du transistor.

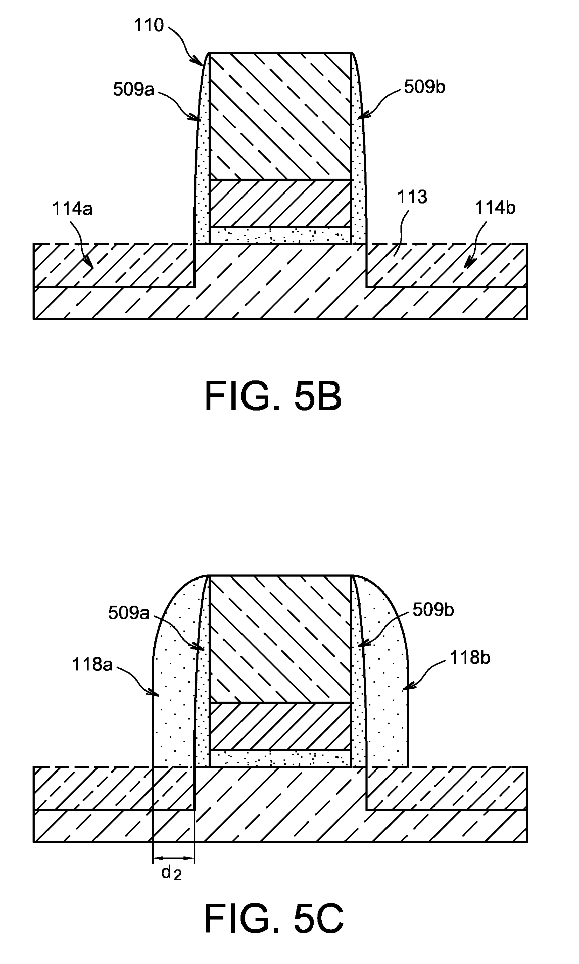

Selon une autre variante de réalisation (figures 5A-5C) du procédé décrit précédemment en liaison avec les figures 2A-2F, en particulier lorsque la grille 110 comporte une couche métallique 108, on peut former des zones 509a, 509b dites de « masquage » contre les flancs latéraux de la grille 110, de manière à masquer la région métallique 108 de la grille.

Ces zones 509a, 509b de masquage sont réalisées par exemple par dépôt d'un matériau diélectrique, puis gravure de ce matériau diélectrique sur les accès. Les zones 509a, 509b de masquage peuvent avoir une épaisseur d₁ (mesurée dans une direction parallèle [O,x,y] du repère orthogonal [O,x,y,z] indiqué sur la figure 5A) très faible, par exemple, inférieure à 5 nm ou comprise par exemple entre 1 et 4 nm.

Les zones 509a, 509b de masquage peuvent être prévues pour éviter une éventuelle contamination par du métal d'équipement(s) utilisé(s) au cours du procédé, en particulier d'équipement(s) d'épitaxie.

Ensuite, on forme les cavités 112a, 112b de part et d'autre de la grille 110 et de la région de canal du transistor.

Puis, on réalise les zones 114a, 114b sacrificielles, par croissance par épitaxie de matériau semi-conducteur dans les cavités 112a, 112b.

Ensuite, on peut former les espaceurs isolants 118a, 118b d'épaisseur d₂ > d₁ (d₂ étant également mesurée dans une direction parallèle [O,x,y] du repère orthogonal [O,x,y,z] indiqué sur la figure 5A) recouvrant les zones 509a, 509b de masquage (figure 5C).

On peut ensuite effectuer un procédé tel que décrit précédemment en liaison avec les figures 2E-2F, dans lequel on forme à nouveau des cavités 122a, 122b pénétrant sous les espaceurs 118a, 118b et dévoilant les flancs latéraux de la zone de canal du transistor.

Puis, on réalise une croissance de matériau semi-conducteur 123 dans les cavités 122a, 122b de manière à former des blocs 124a, 124b à base de matériau semi-conducteur dopé et/ou adapté pour exercer une contrainte pénétrant sous les espaceurs 118a, 118b et en contact avec la région 103c de canal du transistor.

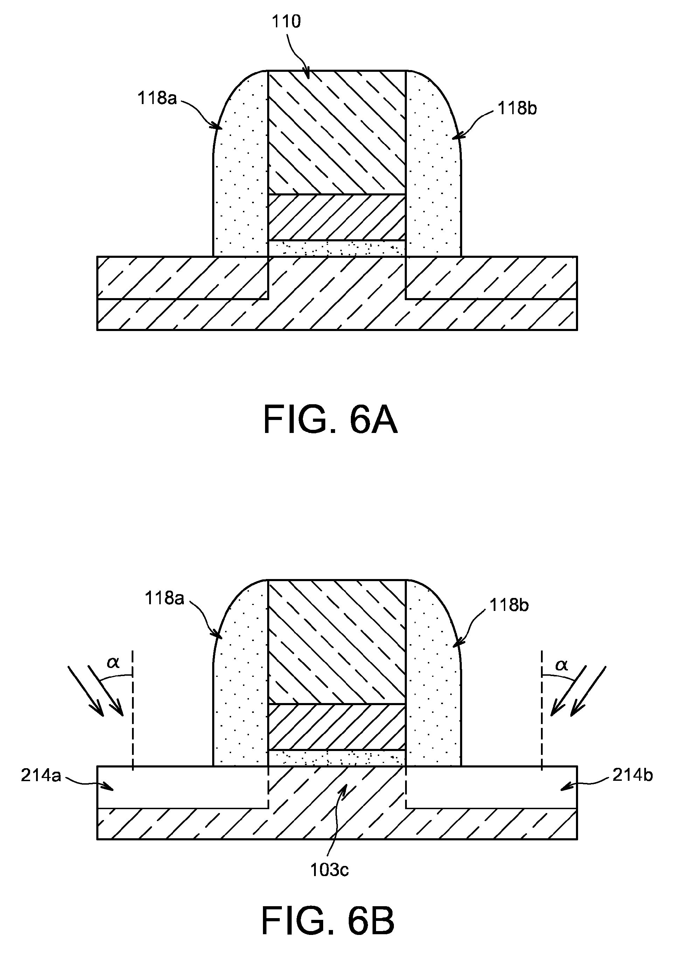

Un procédé différent de celui décrit précédemment en liaison avec les figures 3A-3E, prévoit de réaliser des espaceurs 118a, 118b contre les flancs de la grille 110 du transistor (figure 6A), préalablement à la réalisation de zones sacrificielles.

On forme ensuite les zones sacrificielles 214a, 214b, en rendant amorphes des régions situées de part et d'autre de la zone de canal 103c du transistor et pénétrant sous les espaceurs 118a, 118b.

Pour cela, on réalise une implantation amorphisante (figure 6B) au moyen d'un faisceau incliné réalisant un angle α, non-nul par rapport à une normale n au plan principal du substrat, par exemple compris entre 20° et 50°, par exemple de l'ordre de 45°. L'implantation peut être effectuée par exemple à l'aide de Germanium selon une dose allant de 4 à 8x10¹⁴cm-2 à des énergies comprises entre 3 et 8keV. Cet exemple d'implantation peut être prévu en particulier pour un zone de silicium de 12 nm d'épaisseur où l'on souhaiterait amorphiser une épaisseur de 9 nm d'une zone d'accès à côté des espaceurs et de 6 nm sous les espaceurs pour former les zones sacrificielles 214a, 214b.

On peut ensuite effectuer des étapes telles que décrites en liaison avec les figures 3D-3E consistant à retirer les zones sacrificielles pour former des cavités de part et d'autre de la zone de canal et pénétrant sous les espaceurs, puis remplir ces cavités d'un matériau semi-conducteur dopé et/ou adapté pour exercer une contrainte.

Un procédé suivant l'invention peut s'appliquer à la mise en oeuvre de différents types de structures de transistors et en particulier à la réalisation d'un transistor comportant une structure de canal formée d'un ou plusieurs barreau(x) semi-conducteur(s) tel(s) que les transistors MIGFET (pour « Multiple Independent Gate Field Effect Transistor »), par exemple les transistors de type communément appelé finFET ou tri-gate dont la grille peut s'étendre sur plusieurs plans différents.

## Revendications

1. Procédé de réalisation d'un dispositif microélectronique à transistor(s) comprenant des étapes de :
- formation d'une structure comportant des zones sacrificielles (114a, 114b, 214a, 214b) dans une couche semi-conductrice (103), de part et d'autre d'une région donnée (103c) de cette couche semi-conductrice dans laquelle un canal d'un transistor est destiné à être réalisé, et d'espaceurs isolants (118a, 118b) contre des flancs d'une grille dudit transistor, les espaceurs reposant sur lesdites zones sacrificielles (114a, 114b, 214a, 214b), la réalisation de ladite structure comporte des étapes de :
- formation de zones sacrificielles dans une couche semi-conductrice, les zones sacrificielles étant réalisées de part et d'autre d'une région donnée de cette couche semi-conductrice dans laquelle un canal d'un transistor est apte à être formé, puis
- formation contre une grille dudit transistor reposant sur ladite région donnée d'espaceurs isolants reposant sur lesdites zones sacrificielles, puis,
- retrait desdites zones sacrificielles de manière à former des cavités (122a, 122b) s'étendant de part et d'autre de ladite région donnée et pénétrant sous lesdits espaceurs (118a, 118b),
- formation de matériau semi-conducteur (123) dans lesdites cavités, ledit matériau semi-conducteur pénétrant sous lesdits espaceurs (118a, 118b), ledit matériau semi-conducteur (123) formé dans lesdites cavités et pénétrant sous lesdits espaceurs (118a, 118b) étant dopé, les zones sacrificielles (114a, 114b) étant à base d'un matériau apte à être gravé de manière sélective vis-à-vis de ladite couche semi-conductrice (103).

2. Procédé selon la revendication 1, les zones sacrificielles (114a, 114b) étant à base d'un matériau adapté pour induire une contrainte sur ladite région donnée (103c) de la couche semi-conductrice (103).

3. Procédé selon la revendication 1 ou 2, dans lequel les zones sacrificielles sont réalisées par :
- formation dans la couche semi-conductrice (103) de cavités (112a, 112b) de part et d'autre de la grille (110) dudit transistor,
- remplissage de ces cavités (112a, 112b) à l'aide d'un matériau sacrificiel (113).

4. Procédé de réalisation d'un dispositif microélectronique selon l'une des revendications 1 à 3, dans lequel ladite couche semi-conductrice (103) est à base de Si, les zones sacrificielles (114a, 114b) étant à base de SiGe.

5. Procédé de réalisation d'un dispositif microélectronique selon l'une des revendications 1 à 3, dans le quel ladite couche semi-conductrice (103) est à base de SiₓGe_{y} les zones sacrificielles (114a, 114b) étant à base de SiₐGe_{b} avec b > y.

6. Procédé selon l'une des revendications 1 ou 2, dans lequel ladite couche semi-conductrice (103) à base de matériau semi-conducteur cristallin, les zones sacrificielles (114a, 114b) étant des zones rendues amorphes de cette couche semi-conductrice (103).

7. Procédé selon la revendication 6, dans lequel lesdits espaceurs isolants sont formés par dépôt de matériau diélectrique à une température et selon une durée choisies inférieures respectivement à une température seuil et une durée seuil de manière à conserver le caractère amorphe des zones sacrificielles (114a, 114b) ou à induire une recristallisation d'une épaisseur d'au plus 2 nm de zones sacrificielles (114a, 114b).

8. Procédé de réalisation d'un dispositif microélectronique selon l'une des revendications 1 à 7, dans lequel la grille (110) comprend une zone métallique (108), le procédé comprenant en outre, préalablement à la formation des zones sacrificielles, la réalisation de zones de protection (509, 509b) contre la grille recouvrant ladite zone métallique.

9. Procédé de réalisation d'un dispositif microélectronique selon l'une des revendications 1 à 7, dans lequel les espaceurs isolants sont formés en contact de la grille.

10. Procédé de réalisation d'un dispositif microélectronique selon l'une des revendications 1 à 9 à zones de source et de drain surélevées, ledit matériau semi-conducteur (123) formé dans lesdites cavités (122a, 122b) étant disposé de part et d'autre de la grille (110) au dessus de ladite couche semi-conductrice (103).
